(19) Europäisches Patentamt
European Patent Office
Office européen des brevets

(11) **EP 1 744 455 A2**

(12) **EUROPEAN PATENT APPLICATION**

(43) Date of publication:
**17.01.2007 Bulletin 2007/03**

(51) Int Cl.:
***H03H 21/00*** *(2006.01)*

(21) Application number: **06013953.2**

(22) Date of filing: **05.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **12.07.2005 ES 200501751**

(71) Applicant: **Tredess 2010, S.L.**
**15706 Santiago de Compostela (ES)**

(72) Inventors:
• **Lopez Valcarcel, Roberto**
 **15706 Santiago de Compostela (ES)**

• **Mosquera Nartallo, Carlos**
 **15706 Santiago de Compostela (ES)**
• **Perez Gonzales, Fernando**
 **15706 Santiago de Compostela (ES)**
• **Prieto Davila, Alberto**
 **15706 Santiago de Compostela (ES)**

(74) Representative: **Dosterschill, Peter**
 **Petra & Kollegen**
 **Patentanwälte**
 **Herzog-Ludwig-Strasse 18**
 **85570 Markt Schwaben (DE)**

(54) **Signal processing system for spectrum shaping**

(57) The invention refers to a signal processing system for spectrum shaping constituted by an analog/digital converter (13) which converts the analog signal of interest to digital, an adaptive digital filter (14), and a digital/analog converter (15) which again converts the signal to analog.

The adaptive digital filter (14) adaptively forms the signal spectrum to adjust it to a reference spectrum which may be arbitrary.

Figure 1

EP 1 744 455 A2

**Description**

The present invention relates to a signal processing system for spectrum shaping according to claim 1 and to a signal processing method according to claim 13. The invention is effective for adjusting the spectrum of a signal of interest to a reference spectrum; distortion in a signal of interest is reduced.

A spectrum shaping system adaptively operating in real time can be used to compensate for distortions undergone by a signal of interest, which are not previously known by the processor, and whose nature may vary throughout time. The object of the shaper is to adjust the spectrum of the signal of interest to another reference spectrum, previously specified and which may be arbitrary. The shaper includes an analog-digital converter which samples the signal of interest, a digital filtering system which possesses coefficients which are adaptively varied, and a digital-analog converter which reconstructs the signal with the spectrum adjusted to that of the reference spectrum. The digital filtering system includes an automatic digital gain control which adjusts the power level of the signal of interest, and an infinite impulse response filter, whose coefficients are adapted by a spectrum shaping algorithm. This algorithm operates exclusively on the samples of the signal of interest and the parametric characterization of the reference spectrum, without the need to extract any type of information of the signal of interest such as synchronism marks or training segments, which considerably reduces the complexity of the shaper.

BACKGROUND AND STATE OF THE ART

The operation of components and equipment with characteristics which are not ideal on a signal, as well as the propagation of said signal via a physical media, introduce distortion in said signal. For example, the signal transmitted in a communications system can be affected after its passage through the physical media by effects such as: multipath, in wireless communications; impedance maladjustments, in communications guided by coaxial cable; frequency selectivity, in communications on twisted pair; and multimode dispersion, in fibre optic communications. The signal of interest also may be affected by its passage through the filters present in the transmitting or receiving equipment, whose frequency response will never be perfectly flat in the passband of the signal of interest.

In all cases, the distortion introduced will result in a degradation of the quality of the communications system, measured as rate of error if the communications system is digital, or fidelity of reproduction of the source information of the communications system is analog. These effects on the signal of interest are of linear character and, therefore, they alter the frequency content or spectrum of said signal, being, in principle, its compensation possible by the use of filters. The nature of said effects is in general complicated and varies in time as a consequence of temperature fluctuations, movement of the terminals or of the objects present in the physical media, or changes in the loading conditions of the transmission lines; which hinders its elimination by non-adjustable devices.

A possible method to combat the distortion consisting of the use of adaptive filters which are time-adjusted to counteract at least part of the pernicious effect on the signal. As a particular example of these filters we should cite the interference suppressions systems caused by multipath in analog television receivers (TV), such as that disclosed by C. B. Patel and J. Yang in European Patent EP 0 600 739 A2 of 2-12-1993 and titled "VIDEO GHOST CANCELLATION", and which makes use of segments especially introduced for this purpose in the TV signal and called GCR (Ghost Cancelling Reference) to periodically estimate the correction filter.

Another particular example of these correction filters is found in the systems called equalizers, positioned in the receiver equipment of numerous digital communications systems. In this situation, the equalizer is preceded by an analog-digital converter which obtains a sequence of samples of the signal of interest. The equalizer operates on these samples in order to recreate in its output an estimate of the sequence of digital information carrier symbols originally transmitted. The measurement of the quality of said estimate may serve to adjust the coefficients of the equalizer, using adaptive algorithms. These algorithms may require knowledge by the information receiver incorporated in the signal of interest, such as synchronism marks or training segments, and in said case they are called supervised. Other adaptive algorithms, called blind, only use information of statistical type about the symbols transmitted for the adjustment of the coefficients of the equalizer. The fact that the equalizer tries to reproduce the original sequence of symbols is therefore critical for the functioning of the adaptive algorithms, both supervised and blind.

Nevertheless, there are situations in which the distortion correction filter has to be inserted at a point which does not correspond to the final receiver of the information, such as, for example, in transmitting systems whose purpose is the amplification and retransmission of the signal of interest. In said situations the correction of distortion by an equalizer filter would require a complete demodulator system, after the equalizer and a complete modulator system to regenerate the signal of interest, which would result in excessive cost and complexity.

To avoid these problems it is possible to use an adjustable correction filter whose adaptation is not based on the regeneration of original symbols. A correction system for transmitting equipment presenting distortion due to the coupling between the transmitting and receiving antennas is disclosed by S. J. Highton and W. N. Dominic in European Patent EP 0 772 310 A2 of 7-5-1997 titled "OFDM ACTIVE DEFLECTORS", which requires an initial training stage by the insertion of a pilot signal in the transmission chain. M. R. May and C. A. Greaves disclose in European Patent EP0 833 460 A of 10-9-1997 titled "METHOD AND APPARATUS FOR FREQUENCY DOMAIN RIPPLE COMPENSATION FOR A COMMUNICATIONS TRANSMITTER" a process to compensate the distortion introduced by the analog filters of a transmitter in its passband, as well as the coupling between antennas, measuring said distortion in the frequency domain using Fast Fourier Transform (FTT). There are analog methods, such as that disclosed by M. Suga and S. Isobe in European Patent EP 1 089 513 A1 of 4-4-2001 titled "FREQUENCY CHARACTERISTIC COMPENSATOR FOR OFDM", wherein analog circuits are used by way of spectrum analyser and it adjusts to the response of the compensator filter in accordance with the measurement of the spectrum of the signal of interest. The same inventors disclose in European Patent EP 1 039 716 A1 of 27-9-2000 titled "OFDM TRANSMISSION SIGNAL REPEATER AND RECEIVER" a hybrid analog-digital system which calculates the correction filter from certain estimates in accordance with the self-correlation of the signal of interest. M. Barba *et al.* also present analog and digital method in European Patent EP 1 261 148 A1, of 27-11-2002, titled "METHOD FOR REPEATING ISOFREQUENCY SIGNALS AND ISOFREQUENCY SIGNAL REPEATER" for the adjustment of an adaptive filter whose object is the correction of distortion due to the coupling between transmitting and receiving antennas, which require the introduction of a certain time delay in the path followed by the signal of interest, which allows us to correct the distortion produced by multipath components corresponding to lower delay values than those introduced.

Finally it can be stated that the distortion correction device should use a simple effective architecture to reduce its cost, be capable of blindly adjusting the correction filter without the need to extract information of reference from the signal of interest, and not be limited by the delay values corresponding to the multipath whose distortion should be eliminated.

DESCRIPTION

The object of the present invention is a spectrum shaping system which permits correcting the linear distortions which affect a certain signal of interest. This objective is achieved with a signal processing system for spectrum shaping such as that defined in the claims.

The present invention is based on the fact that the spectrum of the distortion free signal is known a priori, and that the linear distortions which affect the signal are reflected in its spectrum, which will be different from the corresponding spectrum when distortion does not exist. Therefore, it is possible to correct said distortion by shaping the spectrum of the signal of interest, so that it adjusts to the corresponding spectrum when distortion does not exist and which can be considered as reference spectrum. The spectrum shaping is performed by adaptive signal processing, so that an advantage of the present invention consists of the possibility of correcting distortions which vary throughout time.

The description of the present invention specifies the following aspects of its implementation: (1) method of insertion of the adaptive processing element; (2) architecture of the filter used for the adaptive processing; and (3) updating algorithm of the coefficients of said filter.

An example of spectrum shaping system according to the invention is constituted by an analog-digital converter which performs the sampling and quantification of the signal of interest, an adaptive digital filter in charge of correcting the distortion which affects the signal by shaping its spectrum, and a digital-analog converter which again converts the signal to analog.

In another example according to the invention, the spectrum shaping processing system is characterized in that the adaptive digital filter is an infinite impulse response filter (IIR). This has the advantage of permitting the reduction of the number of necessary coefficients in the filter for spectrum shaping, which considerably reduces the cost of system implementation.

In an example of spectrum shaping processing system according to the invention, the adaptive IIR digital filter is implemented by the architecture called direct structure.

In another example of spectrum shaping processing system according to the invention, the adaptive IIR digital filter is implemented by the architecture called lattice structure. This has the advantage of enabling greater simplicity of implementation in the case that it is necessary to monitor the stability of the adaptive filter.

Another example of spectrum shaping processing system according to the invention is characterized in that the adaptive IIR digital filter has coefficients which are adapted according to a spectrum shaping algorithm which adapts the spectrum of the signal of interest into a spectrum called reference spectrum, without needing to extract information of reference from the signal of interest and therefore, blindly operating.

In another example of spectrum shaping processing system according to the invention, the spectrum shaping algorithm has a leaking mechanism, which stabilizes the evolution of the coefficients of the adaptive IIR digital filter.

In another example of spectrum shaping processing system according to the invention, the spectrum shaping algorithm is implemented by means of any of its variants based on the sign function, which has the advantage of reducing the computational cost of the algorithm maintaining good convergence properties.

In another example of spectrum shaping processing system according to the invention, the spectrum shaping algorithm is implemented by means of any of its variants based on sequential adaptation, which reduces the computational cost of the algorithm at the expense of a slower convergence.

In another example of spectrum shaping processing system according to the invention, the spectrum shaping algorithm is implemented in the form of a Gauss-Newton recursion, which has the advantage of considerably accelerating the convergence speed of the coefficients, at the expense of increasing the computational complexity of the adaptive device.

Below, we will illustrate the advantages and characteristics of the invention by the following description, wherein reference is made to the attached figures.

Figure 1    shows a block diagram of the adaptive digital filter.
Figure 2    shows a possible configuration of the digital filtering element.
Figure 3    shows another possible configuration of the digital filtering element.
Figure 4    shows the coefficient adaptation element.
Figure 5    shows the calculation of the coefficients of the digital feedback filter by the adaptive spectrum shaping algorithm.

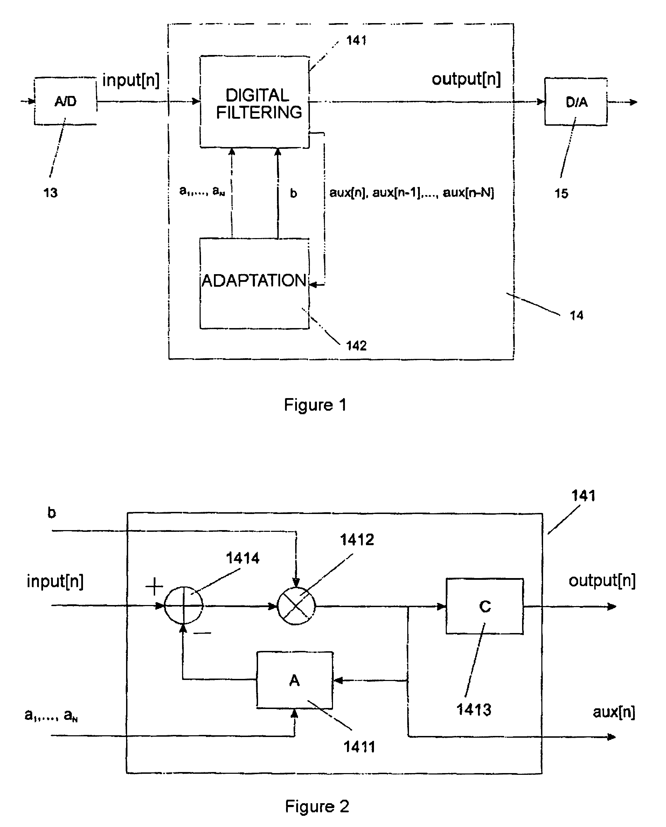

Figure 1 shows the block diagram of the spectrum shaping processing system, which consists of an analog-digital converter 13 which converts the analog signal of interest into digital by sampling; a filter 14 which is digital and adaptive and which processes the samples of the signal of interest; and a digital-analog converter 15 which reconstructs an analog signal from the output samples of the adaptive digital filter 14. The adaptive digital filter 14 is, in turn, composed of a digital filtering element 141 and a coefficient adaptation element 142.

Figure 2 shows the block diagram of a possible configuration of the digital filtering element 141, which is composed of a digital feedback filter 1411, a multiplication stage 1412, a forward digital filter 1413 and a cancellation adding stage 1414. The digital feedback filter 1411 is implemented in a non-limitative manner by the architecture called direct structure, in which case said filter calculates an estimate of the distortion present in the input signal to the digital filtering element 141, called input[n], which is delivered by the analog-digital converter 13, by the weighted addition $a_1 \cdot aux[n-1] + a_2 \cdot aux[n-2] + ... + a_N \cdot aux[n-N]$. This estimate is subtracted from the input[n] signal by the cancellation adding stage 1414 and the result is multiplied by coefficient b via the multiplication stage 1412, to thus obtain the auxiliary aux[n] signal. This operation can be described by the following differential equation:

$$aux[n] = b \cdot \left( input[n] - \sum_{k=1}^{N} a_k \cdot aux[n-k] \right)$$

This auxiliary aux[n] signal is processed by the forward digital filter 1413 to calculate the output[n] signal, which will be delivered to the digital-analog converter 15, by the differential equation:

$$output[n] = \sum_{k=0}^{L} c_k \cdot aux[n-k]$$

Coefficient b which intervenes in the multiplication stage 1412 will be adjustable and will serve to establish the gain of the spectrum shaping system 1 and maintain the power of its output signal equal to a preset reference level. Coefficients $a_1,...,$ aN which intervene in the operation of the digital feedback filter 1411 will also be adjustable and will serve to estimate the distortion existing in the input signal[n], which will be performed via the shaping of the aux[n] signal. Coefficients $c_0,...,c_L$ which intervene in the operation of the forward digital filter 1413 will be fixed and will serve to finally shape the output[n] signal spectrum present at the filter digital 14 output. Nevertheless, the use of the forward filter 1413 is optional and its presence is not strictly necessary for the correct functioning of the spectrum shaping processing system 1. Alternatively, the forward digital filter 1413 may be positioned before the cancellation adding stage 1414. In said case, the auxiliary aux[n] signal coincides with the output signal of the digital filtering element 141, output[n], which is delivered to the digital-analog converter 15. The operation of the digital filtering to produce the aux[n] signal is described below by the following differential equation:

$$aux[n] = b \cdot \left( \sum_{k=0}^{M} c_k \cdot input[n-k] - \sum_{k=1}^{N} a_k \cdot aux[n-k] \right).$$

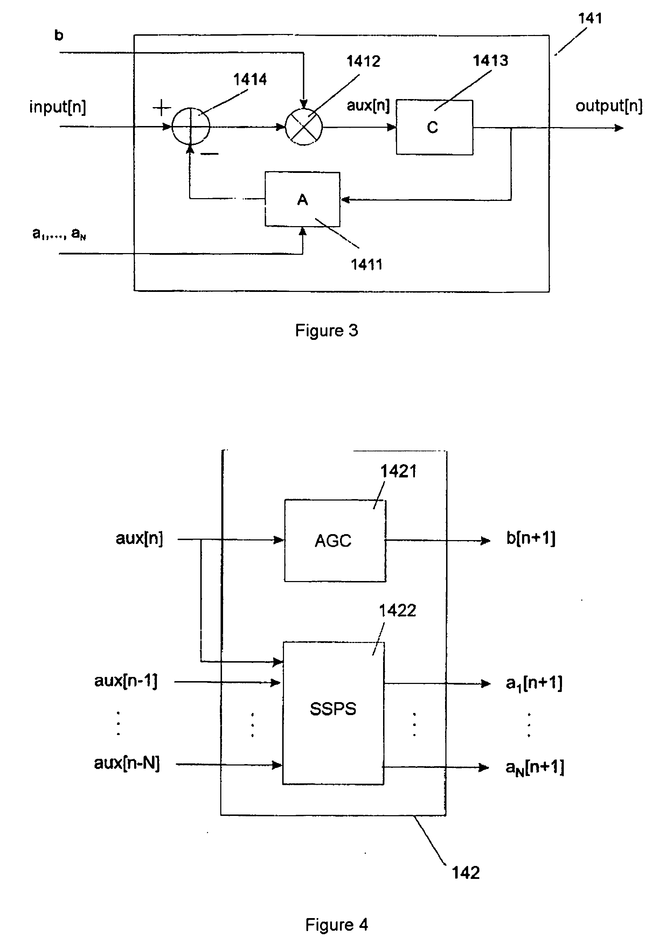

Figure 3 shows another possible configuration of the digital filtering element 141, wherein the forward digital filter 1413 is positioned just after the multiplication stage 1412, so that the signal processed by the digital feedback filter 1411 directly becomes the signal output of the digital filtering element 141, output[n], delivered to the digital/analog converter 15. In said case, the digital filtering operation to produce the output[n] signal is disclosed by the following differential equation:

$$output[n] = \sum_{k=0}^{M} c_k \cdot aux[n-k],$$

whilst the auxiliary aux[n] signal, present at the output of the multiplication stage 1412, would be obtained by the following operation, if the digital feedback filter 1411 is implemented in a non-limitative form by the architecture called direct structure:

$$aux[n] = b \cdot \left( input[n] - \sum_{k=1}^{N} a_k \cdot output[n-k] \right).$$

To adjust coefficients $b$, $a_1$,..., $aN$ of the digital filtering element 141 without external intervention, which makes the system more robust and simpler to handle, a blind or unsupervised algorithm will be used, i.e. it is not necessary to extract reference information such as marking segments or pilot sequences of the signal of interest.

Figure 4 shows the block diagram of the coefficient adaptation element 142, which consists of the automatic gain control element 1421, in charge of performing the adaptation of coefficient $b$ which acts in the multiplication stage 1412 of the digital filtering element 141, as well as another spectrum shaping element 1422, in charge of performing the adaptation of coefficients $a_1$,..., $aN$ which act in the feedback filter 1411 of the digital filtering element 141.

In the spectrum shaping processing system object of the present invention it is necessary to maintain the dynamic input range to the digital-analog converter 15, which may be performed by an automatic gain control element 1421 which adjusts coefficient $b$ acting in the multiplication stage 1412 of the digital filtering element 141 to deal with variation in the signal of interest of its power level. Examples of automatic gain control elements may be found in the book by J. A. C. Bingham titled The Theory and Practice of Modern Design, John Wiley & Sons, 1988. Irrespective of the method used in the automatic gain control element 1421, the mean power level of the aux[n] signal present at the output of the multiplication stage 1412 of the digital filtering element 141 should be maintained at a reference value $R_0$ suitable for the correct functioning of the digital-analog converter 15.

For the adjustment of the coefficients of the digital feedback filter 1411 we have not chosen adaptive algorithms based on the minimization of the mean power at the output of the cancellation adding stage 1414, which are the most common and most widely studied, either under the Minimum Mean Squared Error (MMSE) criterion or under the Least Squares (LS) criterion, as is studied in the book of S. Haykin titled Adaptive Filter Theory, Prentice-Hall, 2001. This decision is due to the fact that under any of these two criteria, the coefficients of the filter would converge to an incorrect solution wherein the signal spectrum at the output of the cancellation adding stage 1414 would tend to be flat and therefore not coincide with the reference spectrum, which would translate in an important residual distortion in the signal of interest. This problem could be alleviated by the introduction of a time-delay element at the output of the cancellation adding stage 1414, whose value has to be sufficiently high to guarantee the non-correlation between values of the signal of interest temporally separated at a greater or equal quantity to the value of the time delay introduced. However, this solution is only partial as the coefficients of the filter would converge at a solution wherein part of the solution would not be eliminated, such as, for example, that produced by the effect of the multipath in the signal of interest if the components of the multipath correspond to time delays of less duration that that of the value of the delay introduced at the cancellation adding stage 1414. Due to this, instead of fixing as an objective for the adaptive algorithm, the minimization of the mean power at the output of the cancellation adding stage 1414, the present invention uses a spectrum shaping criterion as passage towards the elimination of distortion present in the signal of interest. The resulting algorithm described below does not suffer from the problems exposed which affect the schemes based on the MMSE or LS criteria.

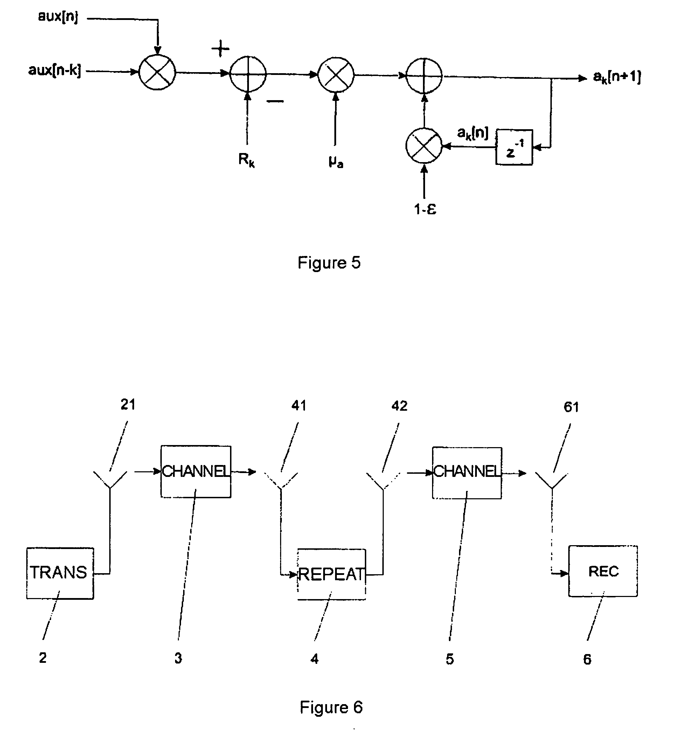

Figure 5 shows the operation of the spectrum shaping element 1422, for the configuration of the digital filtering element 141 shown in figure 2. Said operation corresponds to a spectrum shaping algorithm for the adaptation of the N coefficients $a_1,...,$ aN of the digital feedback filter 1411, which can be accepted as follows:

$$a_k[n+1] = a_k[n] - \varepsilon \cdot a_k[n] + \mu_a \cdot (aux[n] \cdot aux[n-k] - R_k), \quad 1 \le k \le N.$$

This expression describes an adaptive spectrum shaping element. The aux[n] signal is the output of the multiplication stage 1412, whose spectrum should be shaped in order to adjust it as far as possible to that of the reference spectrum.

The constant $\varepsilon$ is either zero or positive and close to zero; in this last case, the algorithm is called leaky, with $\varepsilon$'s mission being to avoid the derivation of coefficients $a_1...a_N$ throughout time, which may be produced, for example, if the signal of interest has little content in some frequency bands; the value of $\varepsilon$ must be suitably chosen by a commitment between the stability against derivation and residual error.

The positive constant $\mu_a$ represents an adaptation step whose value influences the speed of the convergence of the coefficients of the digital feedback filter 1411 and the final residual error around the optimum solution; said value must be suitably chosen by a compromise between rate of convergence and residual error.

The constants $R_1,...,$ $R_N$ specify the reference spectrum to which the spectrum of the auxiliary aux[n] signal is to be adjusted, so that they can be determined in accordance with the signal of interest and the sampling frequency used in the analog-digital converter 13. Thus, the constants $R_1,...,$ $R_N$ may be calculated a priori in accordance with the application, and stored in the spectrum shaping processing system for their use in the spectrum shaping algorithm.

For the configuration of the digital filtering element 141 shown in figure 2, the adaptation of the N coefficients $a_1,...,$ aN of the digital feedback filter 1411 by a variant, based on the sign function, of the spectrum shaping algorithm described may be represented in a non-limitative manner in the following form:

$$a_k[n+1] = a_k[n] - \varepsilon \cdot a_k[n] + \mu_a \cdot (sign(aux[n]) \cdot aux[n-k] - \overline{R}_k), \quad 1 \le k \le N,$$

where the sign function is defined as sign(x) = 1 if x is positive and sign(x) = -1 if x is negative, and the constants $\overline{R}_1,...,$ $\overline{R}_N$ specify the reference spectrum to which the spectrum of the auxiliary aux[n] signal is to be adjusted, so that they can be determined in accordance with the nature of the signal of interest and of the sampling frequency used in the analog/digital converter 13. Thus, the constants $\overline{R}_1,...,$ $\overline{R}_N$ may be calculated a priori in accordance with the application.

The spectrum shaping algorithm referring to the configuration of the digital filtering element 141 shown in figure 2, and in any of its variants, is also applicable to the case wherein the signal of interest takes complex values, as occurs in certain digital communications systems. In said case, the input[n], aux[n] and output[n] signals as well as coefficients $a_1,...,$ aN, $c_0,...,$ $c_L$ of the digital filtering element 141 take complex values, and the adaptation of coefficients $a_1,...,$ aN of the feedback filter 1411 may be expressed in the following form:

$$a_k[n+1] = a_k[n] - \varepsilon \cdot a_k[n] + \mu_a \cdot (aux[n] \cdot (aux[n-k])^* - R_k), \quad 1 \le k \le N,$$

where (aux[n-k])* denotes the complex conjugate of aux[n-k]. The constants $R_1,...,$ $R_N$, which take in this case complex values, are calculated a priori in accordance with the nature of the signal of interest and the sampling frequency used in the analog-digital converter 13.

For the configuration of the digital filtering element 141 shown in figure 3, the spectrum shaping algorithm for the adaptation of the N coefficients $a_1,...,$ aN of the digital feedback filter 1411 is given by the following expression:

$$a_k[n+1] = a_k[n] - \varepsilon \cdot a_k[n] + \mu_a \cdot (aux[n] \cdot salida[n-k] - S_k), \quad 1 \le k \le N.$$

"salida" means "output". The constants $S_1,...,$ $S_N$ specify the reference spectrum to which the spectrum of the auxiliary aux[n] signal is to be adjusted, so that they can be determined in accordance with the nature of the signal of interest and the sampling frequency used in the analog-digital converter 13. Thus, the constants $S_1,..., S_N$ can be calculated a priori in accordance with the application.

The spectrum shaping algorithm described, referring to the configuration of the digital filtering element 141 shown in figure 3, and in any of its variants, is also applicable to the case wherein the signal of reference takes complex values, as occurs in certain digital communications systems. In said case, the input[n], aux[n] and output[n] signals as well as coefficients $a_1,..., aN, c_0,..., c_L$ of the digital filtering element 141 take complex values, and the adaptation of coefficients $a_1,..., a_N$ of the feedback filter 1411 may be represented in a non-limitative manner in the following form:

$$a_k\left[n+1\right] = a_k\left[n\right] - \varepsilon \cdot a_k\left[n\right] + \mu_a \cdot \left(aux\left[n\right] \cdot \left(salida\left[n-k\right]\right)^* - S_k\right), \quad 1 \le k \le N,$$

where ("salida" means "output" and output[n-k])* denotes the complex conjugate of output[n-k]. The constants $S_1,..., S_N$, which take, in this case, complex values, are calculated a priori in accordance with the nature of the signal of interest and the sampling frequency used in the analog-digital converter 13.

DESCRIPTION OF A PREFERRED EMBODIMENT

Below, by way of example and without limitative character, a preferred embodiment is described which consists of a system repeater for digital communications systems in wireless systems, in order to illustrate the advantages and properties of the invention in one of its many possible applications.

The preferred embodiment presented by way of example relates to a process of signal retransmission using a repeater system, which may have coupling between the transmitting and receiving antennas, and which consists of the following stages: (a) reception of a radiofrequency signal; (b) optional conversion of said signal to an intermediate frequency signal; (c) automatic filtering, amplification and control of the power of said signal; (d) analog-digital conversion of said signal to another digitized one; (e) adaptive compensation of the distortion present in said digitized signal and which may be due to any of the following causes: multipath propagation of the source analog signal before reaching the repeater, coupling between the transmitting and receiving antennas of the repeater, or the processing performed by the previous stages of the repeater; (f) digital-analog conversion of the compensated digital signal; (g) optional modulation of the resulting signal to a certain radiofrequency band; (h) power amplification, filtering and transmission of said signal.

The repeater may be incorporated in digital communications systems such as DVB, DAB, GSM, W-CDMA, etc., in those geographical points wherein it is necessary to increase the power level of the signal for its correct reception, it being possible to transmit in the same channel wherein the signal is received, as is done in the isofrequency systems. In this case, there would be a considerable feedback of the transmitting antennas to the receiving antenna of the repeater, which may make the repeater unstable and unusable. The coupling between the antennas may usually be quantified by the Gain margin, defined in decibels as:

$$\text{Gain margin (dB)} = -10\log\frac{\text{Feedback power}}{\text{Power received}},$$

so that the coupling is more severe the less the gain margin is.

To reduce this feedback, highly directional antennas can be used, which increases the cost of the repeater, or the maximum gain of the system may be reduced with the consequent reduction in the repeater coverage. The preferred embodiment of the invention presented here by way of example and without limitative character enables high gains to be used with antennas which are not necessarily directional, with the consequent reduction in costs and increased coverage.

Even if there exists no significant coupling between the repeater antennas, for example if the repeater's input and output channels are different, the distortion the signal of interest undergoes from when it is originally transmitted until it is retransmitted by the repeater, negatively affects the final reception increasing the rate of error. This distortion may be due to the multipath propagation of the signal before reaching the repeater's receiving antenna, as well as the possible imperfections in the conversion chain in analog frequency, filtering and amplification present in the repeater. The present invention permits compensating the distortion introduced by the multipath channel and the analog processing of the repeater, with the consequent reduction in the rate of error obtained in the final reception.

The preferred embodiment presented by way of example is based on the fact that the spectrum of the distortion-free communications signal is known a priori, and that the linear distortions the signal undergoes from when it is initially transmitted is reflected in its spectrum, so that the spectrum of the signal obtained in the repeater will differ from the spectrum of the signal initially transmitted and which is free from distortion. Therefore, it is possible to correct said distortion by shaping the signal spectrum that reaches the repeater, so that it is adjusted to the spectrum of the signal initially transmitted and which may be considered as reference spectrum. For example, the signals generated by the modulation known as COFDM (Coded Orthogonal Frequency Division Multiplexing) have an approximately flat spectrum within the working band and very low power outside said band.

The spectrum shaping performed by the invention is adaptively performed, so that an advantage of the present preferred embodiment, presented by way of example, consists of the possibility of correcting distortions which vary in time, for example due to mobile reflectors present in the environment or to changes in the working point of the analog components of the repeater due to temperature variations.

An example of spectrum shaping system according to the preferred embodiment, presented by way of example, of the invention is constituted by a first analog filter which selects the frequency band of the input signal, a first frequency converter which optionally transfers the spectrum content of the signal to another band centred in the intermediate processing frequency, an analog gain control which adjusts the dynamic margin of the signal to the value specified in the design, an analog/digital converter which performs the sampling and quantification of the signal, an adaptive digital filter in charge of correcting the distortion present in the signal by shaping its spectrum, a digital/analog converter which again converts the signal to analog, a second frequency converter which optionally transfers the spectrum content of the signal to the frequency band corresponding to the repeater's output channel, and an amplifier which increases the output power to guarantee a suitable signal level in the repeater coverage area.

A non-limitative example of the preferred embodiment, presented by way of example, of the invention is described with reference to the attached figures.

Figure 6 shows in a simplified manner the path which the radiofrequency signal follows in a wireless system with repeater (or Gap-Filler).

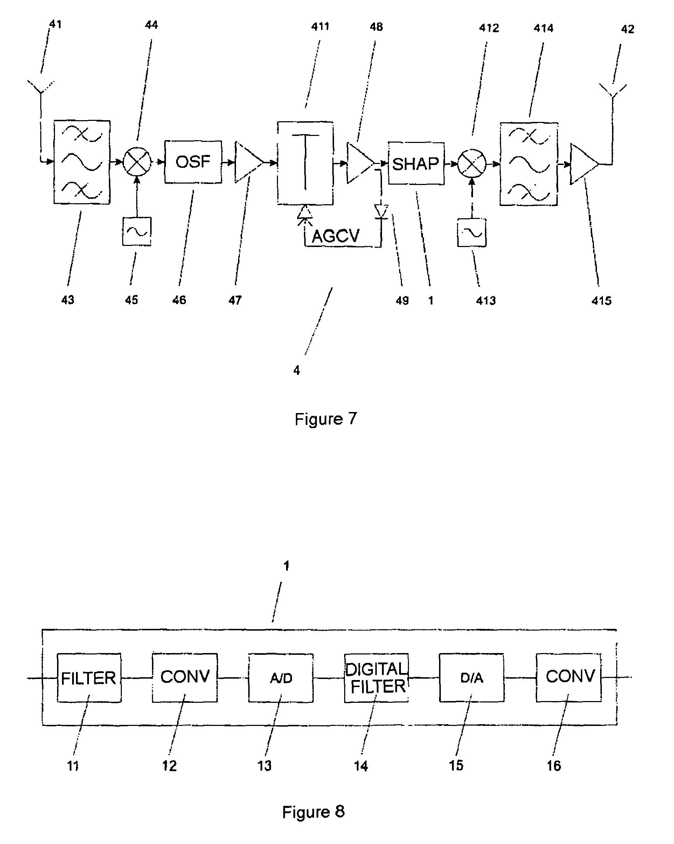

Figure 7 shows a block diagram of a repeater (or Gap-Filler).

Figure 8 shows a diagram of the spectrum shaping system of the preferred embodiment, presented by way of example, according to the invention.

Figure 6 shows a simplified form of the path the radiofrequency signal follows in a wireless system which includes a repeater element, from when it exits the antenna 21 of the transmitter 2 until it is received by the antenna 61 of the receiver 6. In many cases, to ensure a correct reception of the signal, it is necessary to use repeaters (or Gap-Fillers) 4 which amplify the signal to a level that guarantees the coverage of areas which otherwise would not guarantee the suitable reception of the radiofrequency signal. As can be observed, the signal emitted by a transmitting antenna 21 of a transmitter 2 crosses a first multipath channel 3 which joins the antenna 21 to a receiving antenna 41 of a repeater (or Gap-Filler) 4. A second multipath channel 5 is also crossed by the signal from which it is emitted by a transmitting antenna 42 of the repeater 4 until it is captured by a receiving antenna 61 of the receiver equipment 6.

The distortions produced in the multipath channel 3 and 5 and the distortions produced by the repeater (or Gap-Filler) 4 negatively affect signal reception. If the frequency band of the signal at the input of the repeater coincides with the frequency band at the repeater output, as occurs, for example, in isofrequency systems, the coupling which would inevitably occur between the receiving antenna 41 and the transmitting antenna 42, both of the repeater 4, will produce additional distortion in the radiofrequency signal.

To improve the quality of the signal in the receiver 6 these distortions are corrected by a spectrum shaping system 1 according to the invention which is located in the repeater (or Gap-Filler) 4 as can be observed in figure 7.

The spectrum shaping system object of the invention does not require, in principle, the spectrum translation of the signal of interest, although said translation may be performed to facilitate the operation of the conversion circuits without this affecting the principles of functioning of the invention. Thus, figure 7 shows as a non-limitative example, a generic block diagram of a repeater (or Gap-Filler) 4 with a spectrum shaping system 1 according to the invention, wherein the signal of interest is transferred to an intermediate frequency band. As can be observed, the signal from the antenna 41 is processed by a channel filter 43 which rejects the image frequency of the input signal. The filtered signal is introduced in a mixer 44 where it is mixed with the signal generated by a local oscillator 45. The intermediate frequency signal is obtained at the mixer output 44. This signal is introduced in a surface wave filter 46 which eliminates all the undesired mixes produced in the mixer 44.

In this example of application of the invention, the intermediate frequency signal is amplified by the intermediate frequency amplifiers 47 and 48 and detected at the output of the latter by the detector 49. The signal detected is used to generate the automatic gain control voltage AGCV, which, acts on the attenuator 411 so that the signal level at the input of the spectrum shaping system 1 has a constant level for all the input signal values within the dynamic range of the repeater equipment 4.

The output signal of the spectrum shaping system is introduced in a mixer 412, where it is mixed with the local oscillator 413 signal so that the frequency of the channel one wants to transmit is obtained at the mixer 412 output.

The output signal of the mixer 412 is passed through the channel filter 414 in charge of eliminating all the undesired mixing, so that at its output there only appears the signal in the frequency band in which it is to be transmitted.

The resulting signal is passed through the output amplifier 415 in charge of increasing the signal level until the suitable value to be transmitted by the transmitting antenna 42.

Figure 8 shows a non-limitative form of a diagram of the spectrum shaping processing system 1 according to the invention, in a preferred embodiment presented by way of example wherein the spectrum shaping system is inserted in a repeater for radiofrequency signals and wherein the signal of interest is transferred to an intermediate frequency band for its processing. As can be observed, the spectrum shaping processing system 1 is constituted by a first filter 11 which selects the frequency band of the input signal, a first frequency converter 12 which transfers the signal frequency to another frequency called intermediate processing frequency, an analog/digital converter 13 which converts the analog signal to digital by sampling; the digital samples are processed in a filter 14 which is digital and adaptive. The output of the adaptive digital filter 14 is again converted to analog by a digital/analog converter 15; finally, a second frequency converter 16 returns the signal to its original frequency.

In addition to the advantages of distortion reduction shown by the application of the spectrum shaping system of the invention in the preferred embodiment, presented by way of example, of a system repeater (or Gap-Filler), another additional advantage consists of the fact that for the correct functioning of the spectrum shaping algorithm it is not necessary to perform an analog-digital conversion of the signal sent to the transmitting antenna 42 by the output amplifier 415.

An example of preferred embodiment, presented by way of example, of the present invention for a digital communications signal repeater in an isofrequency system develops an implementation of the digital filter in configurable logical devices, such as FPGA, etc.

The invention also refers to a signal processing method for spectrum shaping comprising the steps of:

- an analog/digital converter 13 converts an analog signal of interest to digital,
- an adaptive digital filter 14 adaptively forms the signal spectrum to adjust it to a reference spectrum which may be arbitrary; and
- a digital/analog converter 15 converts the signal to analog.

**Reference list**

| | |
|---|---|
| 1 | Spectrum shaping processing system |
| 11 | Analog filter |
| 12 | First frequency converter |
| 13 | Analog /Digital Converter |
| 14 | Adaptive digital filter |
| 141 | Digital filtering element |
| 1411 | Digital feedback filter |
| 1412 | Multiplication stage |
| 1413 | Forward digital filter |
| 1414 | Cancellation adding stage |
| 142 | Adaptation element |
| 1421 | Automatic digital gain control element |
| 1422 | Spectrum shaping element |
| 15 | Digital/analog converter |
| 16 | Second Frequency converter |
| 2 | Transmitter |
| 21 | Transmitting antenna 2 |
| 3 | Transmitter- Repeater Multipath channel |
| 4 | Repeater (or Gap-Filler) |
| 41 | Repeater receiving antenna 4 |
| 42 | Repeater transmitting antenna 4 |
| 43 | Channel filter |
| 44 | Mixer |
| 45 | Local oscillator |
| 46 | Surface wave filter |
| 47, 48 | Amplifier |
| 49 | Detector |

411    Attenuator
412    Mixer
413    Oscillator
414    Channel filter
415    Output amplifier

5    Repeater - Receiver Multipath channel

**Claims**

1. Signal processing system for spectrum shaping constituted by an analog/digital converter (13) which converts the analog signal of interest to digital, an adaptive digital filter (14), and a digital/analog converter (15) which again converts the signal to analog, **characterized in that** the adaptive digital filter (14) adaptively forms the signal spectrum to adjust it to a reference spectrum which may be arbitrary.

2. Signal processing system for spectrum shaping according to claim 1, **characterized in that** the adaptive digital filter (14) is an infinite impulse response filter.

3. Signal processing system for spectrum shaping according to claims 1 or 2, **characterized in that** the adaptive digital filter (14) is implemented by the architecture called direct structure.

4. Signal processing system for spectrum shaping according to claims 1 or 2, **characterized in that** the adaptive digital filter (14) is implemented by the architecture called lattice structure.

5. Signal processing system for spectrum shaping according to any of the preceding claims, **characterized in that** the adaptive digital filter (14) has coefficients which are adapted according to a spectrum shaping algorithm which is either leaky or non-leaky.

6. Signal processing system for spectrum shaping according to any of the preceding claims, **characterized in that** the adaptive digital filter (14) has coefficients which are adapted according to a spectrum shaping algorithm which is either leaky or non-leaky and/or some of its variants based on the sign function.

7. Signal processing system for spectrum shaping according to any of the preceding claims, **characterized in that** the adaptive digital filter (14) has coefficients which are adapted according to a spectrum shaping algorithm which is either leaky or non-leaky and/or any of its variants based on the sign function, following a cyclic scheme of sequential adaptation where only a subunit of the coefficients is adapted in each sampling range.

8. Signal processing system for spectrum shaping according to any of the preceding claims, **characterized in that** the adaptive digital filter (14) has coefficients which are adapted according to a spectrum shaping algorithm implemented by a Gauss-Newton recursive method.

9. Signal processing system for spectrum shaping constituted by an analog filter (11) which selects the frequency band of the input frequency, a first frequency converter (12) which optionally transfers the signal frequency to another frequency called intermediate processing frequency, an analog/digital converter (13) which converts the analog signal to digital, an adaptive digital filter (14), a digital/analog converter (15) which converts again the analog signal, and a second frequency converter (16) which optionally transfers the signal to another frequency band, **characterized in that** the adaptive digital filter (14) adaptively shapes the signal spectrum to adjust it to a reference spectrum.

10. Signal processing system for spectrum shaping according to claim 9, **characterized in that** the adaptive digital filter (14) which adaptively shapes the signal spectrum acts on the samples of the signal in intermediate frequency (intermediate processing frequency).

11. Signal processing system for spectrum shaping according to claim 9, **characterized in that** the adaptive digital filter (14) which adaptively shapes the signal spectrum acts on the samples of the signal in base band by sampling of its components in phase and quadrature.

12. Telecommunications signal repeater, constituted by at least one receiving antenna (41) and a transmitting antenna (42), a channel filter (43), a mixer (44), a local oscillator (45), a surface wave filter (46), intermediate frequency amplifiers (47) and (48), a detector (49), an attenuator (411), a mixer (412), a local oscillator (413), a channel filter (414) and an output amplifier (415) **characterized in that** it incorporates a signal processing system for spectrum shaping (1) according to any of the the preceding claims and which does not require analog-digital conversion of the signal obtained after the output amplifier (415).

13. Signal processing method for spectrum shaping comprising the steps of

- An analog/digital converter (13) converts an analog signal of interest to digital,
- an adaptive digital filter (14) adaptively forms the signal spectrum to adjust it to a reference spectrum which may be arbitrary; and
- a digital/analog converter (15) converts the signal to analog.

EP 1 744 455 A2

Figure 1

Figure 2

Figure 3

Figure 4

Figure 5

Figure 6

Figure 7

Figure 8

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0600739 A2, C. B. Patel and J. Yang
- EP 0772310 A2
- EP 0833460 A
- EP 1089513 A1
- EP 1039716 A1
- EP 1261148 A1

**Non-patent literature cited in the description**

- **J. A. C. BINGHAM.** The Theory and Practice of Modern Design. John Wiley & Sons, 1988
- **S. HAYKIN.** Adaptive Filter Theory. Prentice-Hall, 2001